Europäisches Patentamt

European Patent Office

Office européen des brevets

(19)

(11) Veröffentlichungsnummer: **0 155 008 B1**

(12) **EUROPÄISCHE PATENTSCHRIFT**

(45) Veröffentlichungstag der Patentschrift: **18.12.91**

(51) Int. Cl.5: **H03H 17/02**

(21) Anmeldenummer: **85103027.0**

(22) Anmeldetag: **15.03.85**

(54) Digitale Filteranordnung zur Aufteilung von Signalen in Teilbänder.

(30) Priorität: **16.03.84 DE 3409817**

(43) Veröffentlichungstag der Anmeldung:
**18.09.85 Patentblatt 85/38**

(45) Bekanntmachung des Hinweises auf die
Patenterteilung:
**18.12.91 Patentblatt 91/51**

(84) Benannte Vertragsstaaten:
**AT BE CH DE FR GB IT LI NL SE**

(56) Entgegenhaltungen:
**EP-A- 0 123 278**

**IEEE TRANSACTIONS ON ACOUSTICS SPE-
ECH AND SIGNAL PROCESSING, Band ASSP-
30, Nr. 5, Oktober 1982, Seiten 709-718, IEEE,
New York, US; L. GAZSI: "Single chip filter
bank with wave digital filters"**

**IEEE 1983 INTERNATIONAL SYMPOSIUM ON
CIRCUITS AND SYSTEMS, New Port Beach,
California, 2.-4. Mai 1983, Band 2, Seiten
845-848, IEEE, New York, US; J.A. NOSSEK et
al.: "Wave digital lattice filters with applications in communication systems"**

(73) Patentinhaber: **SIEMENS AKTIENGESELL-
SCHAFT**
**Wittelsbacherplatz 2**
**W-8000 München 2(DE)**

(72) Erfinder: **Fettweis, Alfred, Prof. Dr.**
**Im Königsbusch 30**
**W-4630 Bochum(DE)**
Erfinder: **Meerkötter, Klaus, Dr.-Ing. Prof.**
**Pohlweg 47-49**
**W-5251 Paderborn(DE)**
Erfinder: **Nossek, Josef, Dr.-Ing.**
**Waldstrasse 17**
**W-8127 Iffeldorf(DE)**

**Beschreibung**

Die Erfindung betrifft eine digitale Filteranordnung gemäß dem Oberbegriff des Patentanspruchs 1.

Zur Bitratenreduktion von Sprachsignalen wird das Quellensignal mit Hilfe einer Filterbank in Teilbänder zerlegt. Diese Teilbänder werden codiert übertragen, z.B. ADPCM, und am Ort der Senke decodiert und in einer weiteren Filterbank wieder rekonstruiert. Es handelt sich dabei um eine sogenannte Teilbandcodierung, für die sich im englischen Sprachgebrauch auch der Ausdruck "subbandcoding" eingebürgert hat. Einzelheiten hierüber finden sich beispielsweise in der Zeitschrift BSTJ 1981, Seiten 1633 bis 1653. Es werden dort Transversal (FIR)-Filter zur Realisierung der Filterbänke verwendet. Allerdings zeigt sich, daß zur verzerrungsfreien Übertragung zu erfüllende Nebenbedingungen (quadratur - mirror-filters) nur näherungsweise erfüllt werden.

Eine Kaskadierung von Wellendigitalfiltern zur Zerlegung in Teilbänder geht aus dem Aufsatz von Gazsi(IEEE Transactions on Acoustics Speech and Signal Processing, Band ASSP-30, Nr. 5, Oktober 1982, Seiten 709 bis 718) hervor. Dort wird auch auf die Notwendigkeit einer Abtastratenreduzierung und einer Invertierung eines der Ausgangssignale hingewiesen. Es findet sich dort aber keinerlei Hinweis auf "perfekte" Rekonstruktion (Allpaß (AP)-Phase) bei Kaskadierung von Analyse und Synthese für die Weiche. Deshalb findet sich auch keine Lehre zum Handeln für eine derartige Einrichtung mit Rekonstruktionseigenschaft.

Der erfindung liegt die Aufgabe zugrunde, den technischen Aufwand dieser bekannten Schaltungen erheblich zu reduzieren und eine möglichst verzerrungsfreie Übertragung zu gewährleisten; es werden deshalb Schaltungen unter Verwendung von Wellendigitalfiltern angegeben, mit denen sich diese Bedingungen erfüllen lassen.

Ausgehend von der eingangs genannten digitalen Filteranordnung wird diese Aufgabe gemäß der Erfindung nach den kennzeichnenden Merkmalen des Patentanspruches 1 gelöst.

Es ist in der später genannten Literaturstelle [14], A. Fettweis, Int. J. CTA, 1,323-337, 1973, die Herleitung des transponierten (Wellendigitalfilters) WDF $N^T$ aus dem ursprünglichen WDF N mit Hilfe des Prinzips der Flußumkehr beschrieben. Dies bedeutet:

Im SFG (Signalflußgraphen) von N werden die Richtungen aller Kanten umgedreht. Die Kanten behalten aber den ihnen zugewiesenen Wert. Verzweigungskanten werden zu Addierern und Addierer zu Verzweigungskanten.

Vorteilhafte Ausgestaltungen sind in den Unteransprüchen angegeben.

Anhand von Ausführungsbeispielen wird nachstehend die Erfindung noch näher erläutert.

Es zeigen in der Zeichnung

Fig. 1    ein Zweitor-Wellendigitalfilter N;

Fig. 2    die linke Seite von Gleichung(4)unter Zuschaltung eines weiteren Wellendigitalfilters mit der transponierten Streumatrix $S^T$;

Fig. 3    eine Anordnung wie in Figur 2, aber unter Verwendung von Multiplizierern zur Halbierung der Abtastrate;

Fig. 4    eine Modifikation des Ausganges der Schaltung von Fig. 3;

Fig. 5    die Realisierung eines 7 Grad Wellendigitalfilters das nur drei Multiplizierer benötigt;

Fig. 6    eine weitere Ausgestaltung unter Verwendung von Wellendigitalfiltern N und N1 und transponierten Wellendigitalfiltern $N_1^T$ und $N^T$;

Fig. 7    die schaltungsmäßige Augestaltung einer interpolierenden Synthese-Filterbank unter Angabe der zugehörigen Koeffizienten $\gamma 1$ bis $\gamma 5$.

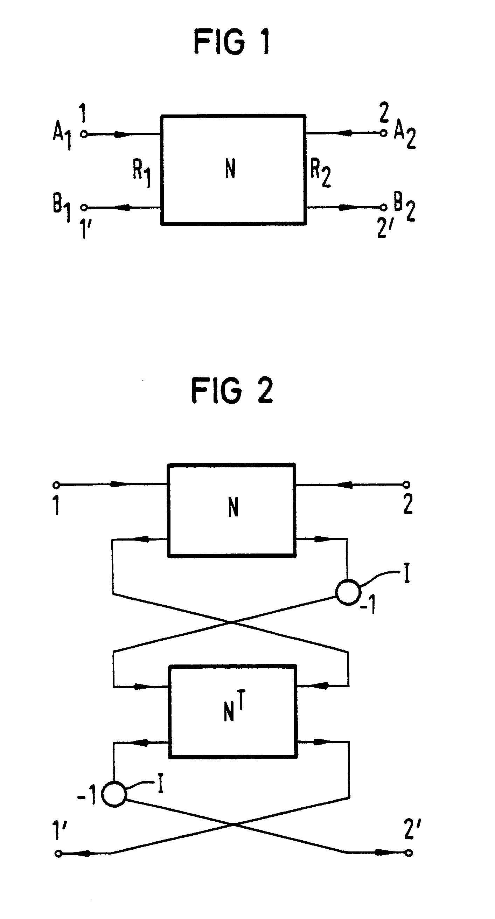

In Fig. 1 ist zum besseren Verständnis nochmal ein Wellendigitalfilter N dargestellt, dessen Eingänge mit 1 und 2 bezeichnet sind und es treten dort entsprechend die Eingangssignale $A_1$ und $A_2$ auf. An den Anschlüssen 1' und 2' treten die Ausgangssignale $B_1$ und $B_2$ auf, zwischen den Toren sind die Torwiderstände $R_1$ und $R_2$ kenntlich gemacht. Einzelheiten über solche Wellendigitalfilter finden sich beispielsweise in den Literaturstellen des beigefügten Literaturverzeichnisses, insbesondere in AEÜ 25, 79-89, 1971.

In Fig. 2 sind zwei Wellendigitalfilter geschaltet und zwar ein Wellendigitalfilter N und ein Wellendigitalfilter $N^T$. Es sind wiederum zu erkennen die Eingangsleitungen 1 und 2 sowie die Ausgangsleitungen 1' und 2'. Die Ausgänge des Wellendigitalfilters N werden nun gewissermaßen sich überkreuzend den Eingängen des Wellendigitalfilters $N^T$ zugeführt, wobei in der einen Verbindungsleitungen ein Vorzeicheninverter (-1) I zugeschaltet ist. Diese Leitungen führen nun auf die Eingänge des Wellendigitalfilters $N^T$ und es sind dessen Ausgänge mit den Ausgängen 1' und 2' der Gesamtschaltung verbunden. Der eine Ausgang des Wellendigitalfilters $N^T$, im Ausführungsbeispiel der auf die Ausgangsleitung 2' führende Ausgang, enthält wiederum einen Vorzeicheninverter (-1)I. Allgemein sei noch darauf hingewiesen, daß z.B. das Wellendigitalfilter N durch eine Streumatrix $\underline{S}$ beschrieben werden kann und es muß dann das Wellendigitalfilter $N^T$ die Streumatrix $S^T$ haben.

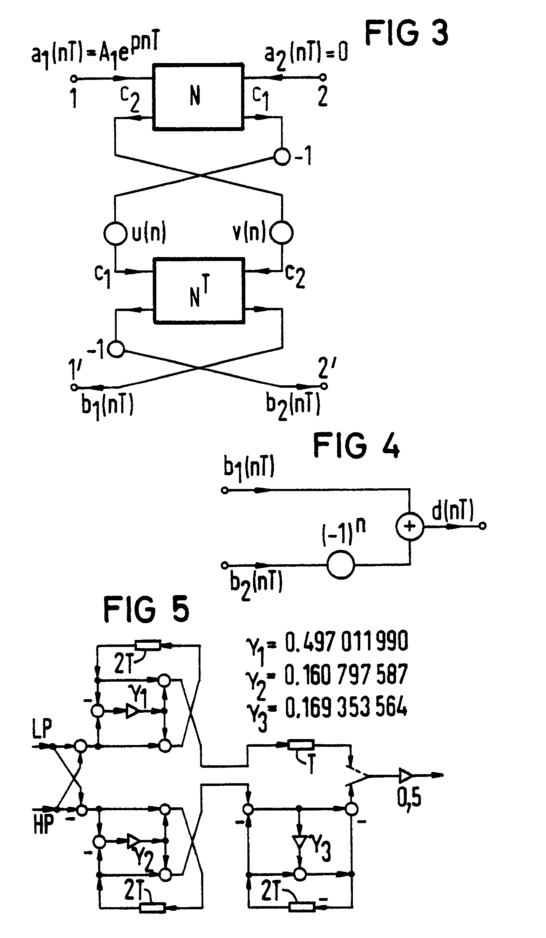

Im Ausführungsbeispiel von Fig. 3 sind die Eingangssignale mit $a_1$ und $a_2$ und die Ausgangssignale mit $b_1$ und $b_2$ bezeichnet. Die weiteren Angaben sind Funktionsangaben, die unmittelbar auch auf Figur 1 Bezug nehmen und auf die später noch eingegangen wird. Die Schaltung von Fig. 3 ist mit der von Fig. 2 praktisch identisch, jedoch werden dem Wellendigitalfilter $N^T$ noch die Multiplizierer $u(n)$ und $v(n)$ zugeschaltet. Um dies kenntlich zu machen, sind die Eingangssignale dort mit $c_1$ Und $c_2$ bezeichnet.

Eine mögliche Modifikation ist in Fig. 4 gezeichnet, wo zu erkennen ist, daß die Ausgangssignale $b_1$ und $b_2$ über Invertierer $(-1)^n$ und einen nachfolgenden Summierer zum Ausgangssignal $d(nT)$ zusammengeschaltet sind.

In Fig. 5 ist die mögliche Realisierung eines Wellendigitalfilters vom Grad 7 gezeigt, bei dem nur drei Multiplizierer mit den Multiplikationskoeffizienten $(\gamma_1, \gamma_2$ und $\gamma_3)$ erforderlich sind.

Die einzelnen Schaltungspfade werden über die mit "Plus" gekennzeichneten Addierer miteinander verbunden, weiterhin sind noch Verzögerungsglieder der Verzögerungszeit T bzw. 2T vorgesehen und schließlich sind auch die bereits erwähnten Multiplizierer $(\gamma_1, \gamma_2, \gamma_3)$ enthalten. Zu erkennen sind ferner die Eingangspfade LP und HP, und es erfolgt die Zusammenfassung am Ausgang über einen Multiplizierer mit da Koeffizienten 0,5. Einige der Addierer können auch durch Subtrahierer ersetzt sein, wie dies durch das Minuszeichen kenntlich gemacht ist.

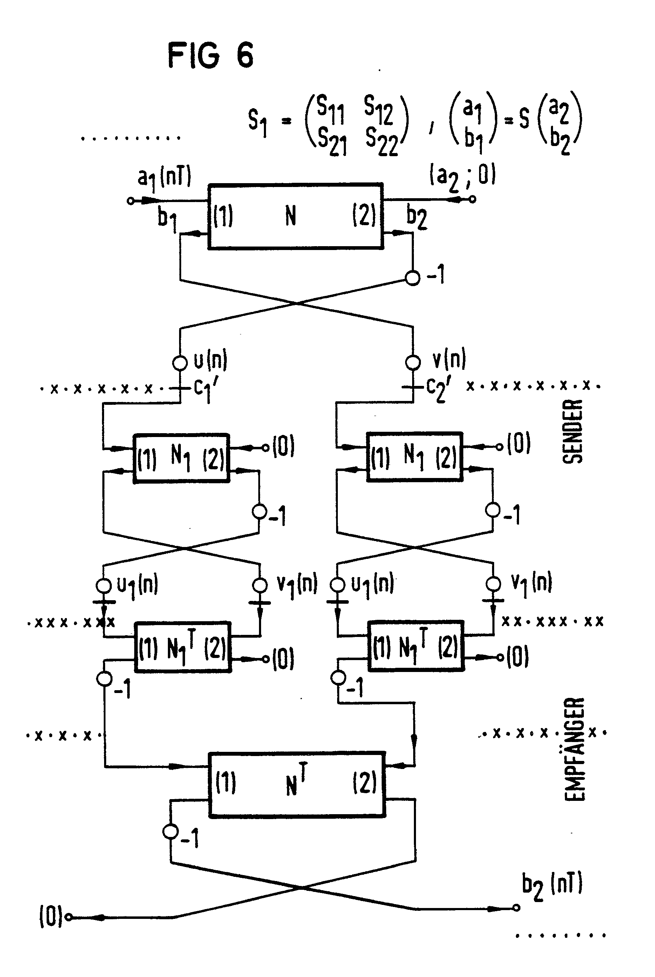

Im Ausführungsbeispiel von Fig. 6 ist zu erkennen ein Wellendigitalfilter N, dem zwei weitere Wellendigitalfilter $N_1$ nachgeschaltet sind.

Die Zusammenfassung der Ausgangssignale $b_1$ und $b_2$ erfolgt auch hier gewissermaßen über eine "Kreuzschaltung" beim Signal $b_2$ noch über einen Vorzeicheninverter "-1". Den weiteren Verbindungsleitungen sind zugeschaltet Multiplizierer $u(n)$ und $v(n)$, an denen dann die Signale $c_1$ und $c_2$ auftreten. Die Signale $c_1$ bzw. $c_2$ werden den ersten Eingängen des Wellendigitalfilters $N_1$ zugeführt, dessen zweiter Eingang kein Eingangssignal (O) erhält. In einer der Ausgangsleitungen folgt dann wieder ein Invertierer (-1) und es folgen anschließend die Multiplizierer $u_1(n)$, $v_1(n)$. Damit ist die sendeseitige Schaltung vollständig. Auf der empfängerseitigen Seite müssen nun die Signale in entgegengesetzer Reihenfolge über die transponierten Wellendigitalfilter $N_1^T$ bzw. $N^T$ zusammengesetzt werden. Es geschieht dies gewissermaßen in entgegengesetzer Reihenfolge, jeweils unter Zuschaltung von Invertern "-1", jedoch ohne Verwendung von Multiplizierern und es ist dann an dem einen Ausgang des transponierten Wellendigitalfilters $N^T$ das Ausgangssignal $b_2$ $(nT)$ vorhanden.

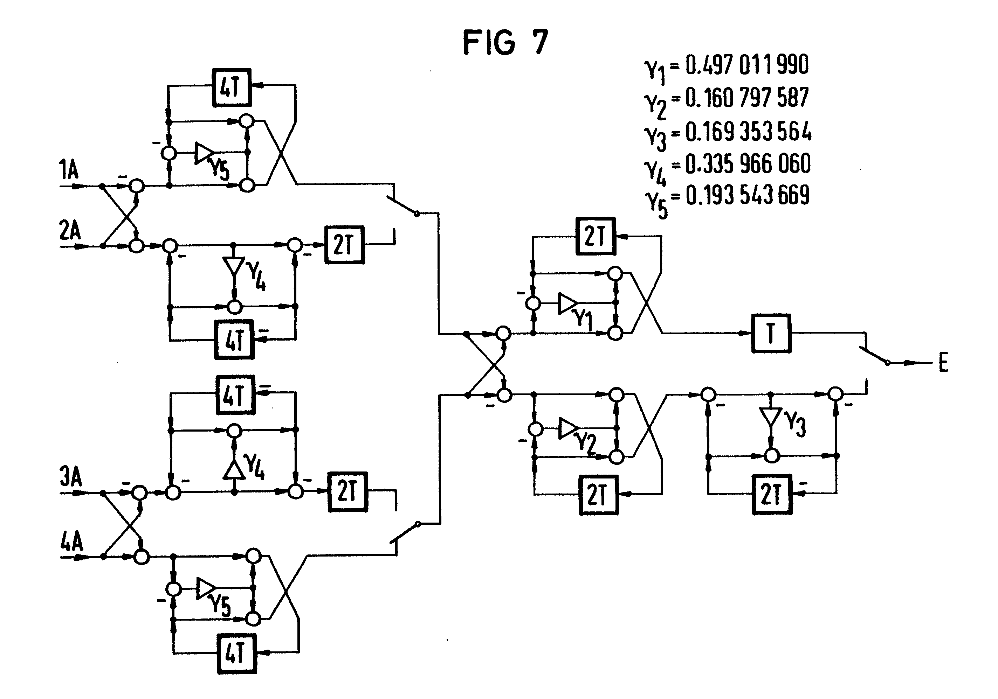

In Fig. 7 ist eine interpolierende Filterschaltung gezeigt, die Eingänge sind mit 1A, 2A, 3A und 4A bezeichnet sind. Der Ausgang ist mit E bezeichnet. Wie in Fig. 5 handelt es sich auch hier um eine mögliche Gesamtschaltung, bei der dann auch entsprechende weitere Multiplizierer benötigt werden. Diese Multiplizierer sind dort mit $\gamma_1$ bis $\gamma_5$ bezeichnet, die einzelnen Funktionen können unmittelbar dem zugehörigen Schaltbild entnommen werden. Es müssen lediglich weitere Verzögerungsglieder mit der Verzögerungszeit 4T verwendet werden, was ebenfalls der Schaltung entnommen werden kann.

Zur weiteren Erläuterung sei noch folgendes ausgeführt.

Ein Wellendigitalfilter (WDF) Zweitor hat zwei Eingangs - und zwei Ausgangsanschlüsse. Wenn man dies in geeigneter Weise benutzt und ein Wellendigitalfilter mit seinem transponierten Wellendigitalfilter verbindet, ist die Filterwirkung vollständig kompensiert mit Ausnahme von einer Allpaßphase, und dies unabhängig von Selektivitätsforderungen. Dieser Gesichtspunkt trifft auch dann zu, wenn an den Verbindungspunkten jede zweite Abtastprobe auf Null reduziert ist, vorausgesetzt, daß eine bestimmte Bedingung, die jedoch leicht einzuhalten ist, erfüllt ist. Sehr wirkungsvolle Lösungen sind dann möglich.

Die Methode ist beispielsweise besonders bei der Teilbandcodierung von Interesse.

Einer der interessierenden Aspekte von Wellendigitalfiltern (WDFs) ist, daß sie tatsächlich über Tore zugänglich sind, das heißt also über Anschlußtore, von denen jedes aus einem Eingangs- und einem Ausgangsanschluß besteht [1,2]. Damit stellt gewissermaßen ein herkömmliches Filter ein Zweitor dar, ein herkömmliches Wellendigitalfilter weist zwei Eingangsanschlüsse und zwei Ausgangsanschlüsse auf. Es besteht damit die Möglichkeit, daß die Filter komplementäre Übertragungseigenschaften haben [3 bis 6]. Anhand der beigefügten Figuren wird nachfolgend gezeigt, wie einige weitere interessante Eigenschaften erhalten werden können, wenn zwei oder mehr Wellendigitalfilter miteinander verbunden werden, wobei man wohl von der Tatsache Gebrauch macht, daß jedes dieser Wellendigitalfilter mehr als nur einen Anschluß und mehr als nur einen Ausgang zur Verfügung hat.

Die einfachste dieser Anordnungen wird mit Fig. 2/3 analysiert. Es wird dabei gezeigt, daß durch eine entsprechende Verbindung eines ersten Wellendigitalfilters mit seinem transponierten Wellendigitalfilter, der Filtereffekt vollständig kompensiert wird bis auf eine Allpaßübertragungsfunktion. Eine Modifikation dieser Anordnung, die eine Abtastratenerniedrigung in der Weise bewirkt, daß bei jeder zweiten Abtastprobe Nullen an den Verbindungspunkten gesetzt werden, wird dann beschrieben. Auch hier wird wiederum eine volle Kompensation mit Ausnahme von einer Allpaßfunktion erreicht, wenn das Wellendigitalfilter einer passenden Bedingung genügt. Diese Bedingung kann ohne weiteres eingehalten werden, insbesondere für symmetrische und antimetrische Filter, deren charakteristische Funktion selbstreziprok ist, in welchem Fall drastische Einsparungen der schaltungstechnischen Erfordernisse erreicht werden, insbesondere für symmetrische Filter [5 bis 8].

Das Entwurfsverfahren läßt sich an sich beliebig oft wiederholen. Hinzu kommt, daß es möglich ist, ein Signal nach mehr oder weniger vorgegebenen Filtervorgängen in zwei individuelle Signale zu teilen, für jedes die Abtastrate zu halbieren, den gesamten Prozeß auf jedes der Teilsignale anzuwenden, diesen Prozeß so oft man es wünscht zu wiederholen und das Amplituden-Frequenz-Verhalten des Originalsignals zu rekonstruieren, selbst wenn die beteiligten Filter in den verschiedenen Schritten keine vorgegebenen Selektivitätsforderungen haben. Im speziellen ist die Methode anwendbar zur Erzielung einer exakten Lösung des Problems für sogenannte Quadratur-Spiegelfilter gemäß den Literaturstellen[9]bis[12] die in Teilbandcodierungsschaltungen [10, 11, 13 (subband-Coding)] angewendet werden.

Betrachtet sei nun anhand der Fig. 1 eine Anordnung mit einheitlicher Abtastrate und es ist dort das einleitend schon beschriebene Wellendigitalfilter N zu erkennen. Schreibt man

$$\underline{B} = \underline{S}\underline{A} \tag{1}$$

$$\underline{A} = (A_1, A_2)^T, \qquad \underline{B} = (B_1, B_2)^T$$

wobei A und B die Vektoren für die einfallenden und reflektierten Wellengrößen sind und wobei S die Streumatrix des Wellendigitalfilters N ist und das hochgesetzte T die Transposition bedeutet. Die Matrix S ist also gleich der Spannungswellenstreumatrix des Referenzfilters $N_R$ von dem N abgeleitet ist. Dadurch, wenn S' die übliche Streumatrix von $N_R$ ist, ergibt sich

$$\underline{S} = \underline{R}^{-1/2} \underline{S}' \underline{R}^{-1/2}, \underline{R} = \text{diag}(R_1, R_2) \tag{2}$$

R ist dabei die Diagonalmatrix die sich aus den Torwiderständen $R_1$ und $R_2$ zusammensetzt. Man kann annehmen, daß Gleichung(1)auf stationären Bedingungen beruht, so daß also die Größen $A_1$, $A_2$, $B_1$ und $B_2$ komplexe Konstante sind.

Nimmt man an, daß $N^T$ eine transponierte von N ist, das heißt also ein Wellendigitalfilter, für das B = $S^T A$ gilt. Bekanntlich kann $N^T$ abgeleitet werden aus N durch eine Anwendung der Flußumkehr [14]. Es ist in dieser Literaturstelle [14] die Herleitung des transponierten (Wellendigitalfilters) WDF $N^T$ aus dem ursprünglichen WDF N mit Hilfe des Prinzips der Flußumkehr beschrieben. Dies bedeutet:

Im SFG (Signalflußgraphen) von N werden die Richtungen aller Kanten umgedreht. Die Kanten behalten aber den ihnen zugewiesenen Wert. Verzweigungskanten werden zu Addierern und Addierer zu Verzweigungskanten.

Im einzelnen sind die Werte der Multipliziererkoeffizienten in $N^D$ dann die gleichen wie in N, das heißt für ein gegebenes N läßt sich das korrespondierende $N^T$ ohne Näherung erhalten. Für $\underline{S}$ und $\underline{S}^T$ können wir dann schreiben

$$\underline{S} = \begin{pmatrix} S_{11} & S_{12} \\ S_{21} & S_{22} \end{pmatrix}, \qquad \underline{S}^T = \begin{pmatrix} S_{11} & S_{21} \\ S_{12} & S_{22} \end{pmatrix} \tag{3a,b}$$

Es läßt sich deshalb zeigen, daß auch Gleichung 4 gilt

$$\underline{E}^T \underline{S}^T \underline{E} \underline{S} = 1 . \det \underline{S} \tag{4}$$

wobei

4

$$\underline{E} = \begin{pmatrix} 0 & -1 \\ 1 & 0 \end{pmatrix} \; , \; \underline{1} = \begin{pmatrix} 1 & 0 \\ 0 & 1 \end{pmatrix}. \tag{5}$$

Wie in Fig. 2 bereits erläutert, kann die linke Seite von Gleichung(4)als die Streumatrix der dort dargestellten Gesamtschaltung angesehen werden. Für diese Anordnung, die Übertragungsfunktion von den Anschlüssen 1 nach 2' und von den Anschlüssen 1' nach 2 sind so gleich Null und damit von den Anschlüssen 1 nach 1' und von 2 nach 3' sind beide det $\underline{S}$. Andererseits erhält man von Gleichung(2)

$$\det \underline{S} = \det \underline{S}' \tag{6}$$

Es ist an sich bekannt, daß für ein verlustfreies $N_R$ det S eine Allpaßfunktion ist [15]. Die Anordnung von Fig. 2 hat also die Wirkung, daß eine Allpaß-Phasenverschiebung eingeführt wird.

Wie einleitend schon erwähnt, unterscheidet sich die Schaltung von Fig. 3 von der Schaltung nach Fig. 2 durch die Einschaltung der zusätzlichen Multiplizierer u(n) und v(n) um im speziellen Ausführungsbeispiel von Fig. 3 die Abtastrate zu halbieren. Die Funktionen u(n) und v(n) nehmen abwechselnd die Worte 1 und Null an und sind so entweder in Phase oder in Gegenphase. Man kann dies gemäß Gleichungen(8)und(9)- darstellen.

$$u(n) = [1 + (-1)^n]/2 = \tfrac{1}{2} (1 + e^{jn\Omega T/2}) \tag{8}$$
$$v(n) = \overline{u(n)} \; ; \; v(n) = 1 - u(n) = \tfrac{1}{2} (1 - e^{jn\Omega T/2}) \tag{9}$$

Dabei ist

$$\Omega = 2\pi F = 2\pi/T, \tag{9'}$$

auch gilt

$$\psi = \tanh (pT/2) = (z-1)/(z+1) \tag{10}$$

und es ergeben sich somit für die Signale $c_1$ und $c_2$ die folgenden Werte

$$c_1 = \tfrac{1}{2} A_1 \, S_{21} (\psi)[e^{pnT} + e^{(p+j\Omega/2)nT}] \tag{11}$$
$$c_2 = \tfrac{1}{2} A_1 \, S_{11} (\psi)[e^{pnT} \pm e^{(p+j\Omega/2)nT}] \tag{12}$$

Die Signale $b_1(n+T)$ am Ausgang 1' und $b_2(n+T)$ am Ausgang 2' gehorchen dann den Gleichungen (13)und (14)

$$b_1(nT) = \tfrac{1}{2} A_1 \det\underline{S} (\psi) \cdot e^{pnT} + \tfrac{1}{2} A_1 \left[ \pm S_{11}(\psi) \, S_{22} \left(\tfrac{1}{\psi}\right) \right. $$
$$\left. - S_{21}(\psi) \, S_{12} \left(\tfrac{1}{\psi}\right) \right] e^{(p+j\frac{\Omega}{2})nT} \tag{13}$$

$$b_2(nT) = \tfrac{1}{2} A_1 \left[ \mp S_{11}(\psi) S_{21} \left(\tfrac{1}{\psi}\right) + S_{11} \left(\tfrac{1}{\psi}\right) S_{21}(\psi) \right] e^{p+j\frac{\Omega}{2}nT}. \tag{14}$$

Da Gleichung 15 gilt

EP 0 155 008 B1

$$S_{21}(\psi)\, S_{12}\left(\tfrac{1}{\psi}\right) = \pm\, S_{11}(\psi) S_{22}\left(\tfrac{1}{\psi}\right) \qquad (15)$$

enthält das Ausgangssignal am Ausgangsanschluß 1' keine anderen Frequenzkomponenten als das Eingangssignal. Dieses Ergebnis bleibt auch erhalten, unabhängig von der Ausgestaltung des Wellendigitalfilters N, und selbst wenn dieses Wellendigitalfilter beispielsweise nur sehr geringe Trennforderungen für das ursprüngliche Signal in einzelnen Frequenzbändern erfüllt und das unabhängig von der Tatsache, daß jeder zweite Abtastwert auf Null gesetzt wird durch die Verwendung der Multiplizierer u(n) und v(n). An einem der Ausgänge 2' oder 1' steht also das rekonstruierte Signal in invertierter oder nichtinvertierter Form zur Verfügung.

In der Schaltung von Fig. 4 werden die Ausgangssignale $b_1(nT)$ und $b_2(nT)$ der Schaltung von Fig. 3 zu einem neuen Ausgangssignal d(nT) in dem dort mit "+" kenntlich gemachten Addierer zusammengefügt. Das Ausgangssignal $b_2$ läuft über einen Vorzeicheninverter $(-1)^n$. Es läßt sich damit also der Wert des Ausgangssignals d(nT) verdoppeln.

Bei dem in Fig. 5 dargestellten Wellendigitalfilter vom Grad 7 sind ein Tiefpaß LP und ein Hochpaß HP zusammengeführt. Es werden nur 3 Multiplizierer benötigt, die folgende Werte haben: $\gamma_1 = 0{,}497011990$; $\gamma_2 = 0{,}160797587$; $\gamma_3 = 0{,}169353564$.

Für die in Fig. 6 dargestellte Schaltung kann unmittelbar auf das Vorherstehende zurückgegriffen werden. Auf der Senderseite "Sender" werden also die in ihrer Abtastrate herabgesetzten Weichen-Ausgangssignale $c_1$ und $c_2$ über weitere Wellendigitalfilter $N_1$ frequenzmäßig aufgeteilt und wiederum in ihrer Abtastrate reduziert. Entsprechend müssen dort die Multiplizierer $u_1$, $v_1$ vorgesehen werden. Auf der Empfängerseite "Empfänger" werden diese Signale über die transponierten Wellendigitalfilter $N_1{}^T$ weiterverarbeitet und im ausgangsseitigen Wellendigitalfilter $N^T$ zusammengefaßt, so daß dort nach dem Inverter $(-1)$ das Ausgangssignal $b_2(nT)$ abgenommen werden kann.

Die in Fig. 7 dargestellte Schaltung wurde an sich schon detailliert besprochen, die Multiplikationsfaktoren $(\gamma_1 \text{bis} \gamma_5)$ sind unmittelbar in der Zeichnung angegeben. Hingewiesen sei nochmals darauf, daß die dort mit T bzw. 2T bzw. 4T kenntlich gemachte Blockschaltbilder als Laufzeitverzögerungen der Laufzeit T bzw. 2T, bzw. 4T aufzufassen sind.

Auch in der digitalen Technik ist es möglich, Filter zu realisieren, deren charakteristische Funktionen c $(\psi)$ zueinander selbstreziprok sind bzw. bei denen auch die charakteristischen Funktionen der Referenzfilter zueinander selbstreziprok sind. Diese mathematische Bedingung ist dann erfüllt, wenn

$$c(1/\psi) = 1/c(\psi) \qquad (16)$$

erfüllt ist. Wenn zusätzlich diese Bedingung eingehalten ist, dann vermindert sich auch der schaltungstechnische Aufwand der hier beschriebenen Anordnungen erheblich. Sogenannte Brückenwellendigitalfilter sind ebenfalls für sich bekannt, so das an dieser Stelle nicht näher darauf eingegangen werden muß.

Abgesehen von den bereits genannten Vorteilen hat die hier angegebene Dimensionierungsmethode noch den Vorteil, daß eine exakte Amplitudenreproduktion des Spektrums des ursprünglichen Signals auch dann erreicht wird, wenn die Koeffizienten in willkürlicher Weise gerundet werden.

**LITERATURSTELLEN**

[1]   A.Fettweis,AEO,25,79-89,1971.
[2]   -,Lecture Notes, ECCTD, Stuttgart, Germany,1983.
[3]   -,Proc.Florence Seminar on Dig.Filt.,Florence,72.
[4]   M.Bellanger,D.Didier,Câbles et Transm., 31,497-506,1977.
[5]   W.Wegener,AEO,33,239-243,1979.
[6]   A.Fettweis IEEE Trans.COM,30,1575-1586,1982.
[7]   J.A.Nossek,H.-O.Schwartz,Proc.ISCAS,845-848, Newport Beach,CA,1983.
[8]   K.Meerkötter,Proc.ECCTD,217-220,Stuttgart,1983.
[9]   D.Esteban,C.Galand,Proc.ICASSP,191-195,Hartford, Conn.,1977.
[10]  E.R.Crochiere,BSTJ,747-770,1977.
[11]  T.A.Ramstad.O.Foss,Proc.EUSIPCO,747-752,Lausanne, Switzerland,1980.
[12]  H.J.Nussbaumer,C.Galand,Proc.EUSIPCO,69-72. Erlangen,Germany,1983.
[13]  R.E.Crochiere,BSTJ,60,1633-1653,1981.
[14]  A.Fettweis,Int.J.CTA,1,323-337,1973.
[15]  V.Belevitch,Classical Network,Theory,Holden-Day, San Francisco,CA,1968.

## Patentansprüche

1. Digitale Filteranordnung zur Aufteilung von Signalen in Teilbänder, Reduktion der Abtastrate und nachfolgender Rekonstruktion dieser Signale unter Verwendung von Wellendigitalfiltern,
**dadurch gekennzeichnet,**
daß zur Aufteilung des Frequenzbandes des Eingangssignals ($a_1$) ein Wellendigitalfilter (N) als strenge Weiche geschaltet ist, daß die Signale ($c_1$, $c_2$) an den beiden Weichenausgängen in ihrer Abtastrate um den Faktor zwei herabgesetzt werden und eines dieser Signale ($c_1$) invertiert wird (-1), und daß zur Zusammenfügung diese Signale durch Einfügen von Nullabtastwerten in der Abtastrate wieder um den Faktor 2 heraufgesetzt ($c_1$, $c_2$) und den beiden Eingängen eines transponierten Wellendigitalfilters ($N^T$) zugeführt werden, so daß an einem der Ausgänge (2', 1') ein Signal ($b_2$, $b_1$) in invertierter oder nicht invertierter Form zur Verfügung steht, das sich vom Eingangssignal ($c_1$) nur durch eine Allpaßübertragungsfunktion unterscheidet und somit das rekonstruierte Signal ist.

2. Digitale Filteranordnung nach Anspruch 1, **dadurch gekennzeichnet,** daß die in ihrer Abtastrate herabgesetzten Weichenausgangssignale ($c_1$, $c_2$) ihrerseits über weitere Wellendigitalfilterweichen ($N_1$) frequenzmäßig aufgeteilt und in ihrer Abtastrate nochmals reduziert werden, so daß diese Signale anschließend über weitere transponierte Wellendigitalfilter ($N_1^T$) zusammengefügt und dem transponierten Wellendigitalfilter ($N^T$) zugeführt werden.

3. Digitale Filteranordnung nach Anspruch 1 oder 2, **dadurch gekennzeichnet,** daß die Wellendigitalfilter als Brückenwellendigitalfilter mit selbstreziproker charakteristischer Funktion ausgeführt sind und die im Filter auftretenden arithmetischen Operationen im Rhythmus der reduzierten Abtastrate ausgeführt werden.

## Claims

1. Digital filter arrangement for dividing up signals into subbands, reducing the sampling rate and subsequently reconstructing these signals using wave digital filters, characterised in that in order to divide up the frequency band of the input signal ($a_1$), a wave digital filter (N) is connected as a strict filter, in that the sampling rate of the signals ($c_1$, $c_2$) at the two filter outputs is reduced by a factor of two and one of these signals ($c_1$) is inverted (-1), and in that for the purpose of combination, the sampling rate of these signals is raised again by a factor of 2 ($c_1$, $c_2$) by inserting zero sampling values and the signals are fed to the two inputs of a transposed wave digital filter ($N^T$), so that at one of the outputs (2', 1') a signal ($b_2$ $b_1$) is available in inverted or non-inverted form, which signal differs from the input signal ($c_1$) only in its all-pass filter transmission function and is thus the reconstructed signal.

2. Digital filter arrangement according to Claim 1, characterised in that the filter output signals ($c_1$, $c_2$) with reduced sampling rate are divided up themselves via further wave digital filters ($N_1$) in terms of frequency and their sampling rate is reduced once more so that these signals are subsequently combined by means of further transposed wave digital filters ($N_1^T$) and fed to the transposed wave digital filter ($N^T$).

3. Digital filter arrangement according to Claim 1 or 2, characterised in that the wave digital filters are designed as bridge wave digital filters with self-reciprocating characteristic function and the arithmetic operations occurring in the filter are carried out at the rhythm of the reduced sampling rate.

## Revendications

1. Dispositif de filtre numérique servant à répartir des signaux dans des bandes partielles, réduire la cadence d'échantillonnage et reconstituer ultérieurement ces signaux moyennant l'utilisation de filtres numériques d'ondes,
caractérisé par le fait
que pour la subdivision de la bande de fréquences du signal d'entrée ($a_1$), un filtre numérique d'ondes (N) est branché en tant qu'aiguillage strict, que la cadence d'échantillonnage des signaux ($c_1$, $c_2$) présents sur les deux sorties de l'aiguillage sont divisés par le facteur deux et que l'un de ces signaux ($c_1$) est inversé (-1) et que pour la réunion de ces signaux, la cadence d'échantillonnage de ces derniers est à nouveau divisée par le facteur 2 ($c_1$, $c_2$), grâce à l'insertion de valeurs d'échantillonnage nulles, et sont envoyés aux deux entrées d'un filtre numérique d'ondes transposé ($N^T$) de sorte que sur l'une des sorties (2',1'), on dispose d'un signal ($b_2,b_1$) sous forme inversée ou non inversée, qui diffère du signal d'entrée ($c_1$) uniquement par une fonction de transfert passe-bas et par conséquent est le signal reconstitué.

2. Dispositif de filtre numérique suivant la revendication 1, caractérisé par le fait que les fréquences des signaux de sortie de l'aiguillage ($c_1,c_2$), dont la cadence d'échantillonnage est réduite, sont séparés par l'intermédiaire d'autres aiguillages de filtres numériques d'ondes ($N_1$) et que leur cadence d'échantillonnage est encore réduite de sorte que ces signaux sont ensuite réunis par l'intermédiaire d'autres filtres numériques d'ondes transposés ($N_1^T$) et sont envoyés au filtre numérique d'ondes transposé ($N^T$).

3. Dispositif de filtre numérique suivant la revendication 1 ou 2, caractérisé par le fait que les filtres numériques d'ondes sont réalisés sous la forme de filtres numériques d'ondes en pont possédant une fonction caractéristique auto-inverse et que les opérations arithmétiques mises en oeuvre dans ce filtre sont exécutées au rythme de la cadence d'échantillonnage réduite.

# FIG 1

# FIG 2

FIG 3

FIG 4

FIG 5

$$\gamma_1 = 0.497\,011\,990$$
$$\gamma_2 = 0.160\,797\,587$$
$$\gamma_3 = 0.169\,353\,564$$

# FIG 6

$$S_1 = \begin{pmatrix} S_{11} & S_{12} \\ S_{21} & S_{22} \end{pmatrix} \;,\; \begin{pmatrix} a_1 \\ b_1 \end{pmatrix} = S \begin{pmatrix} a_2 \\ b_2 \end{pmatrix}$$

# FIG 7

$\gamma_1 = 0.497\ 011\ 990$
$\gamma_2 = 0.160\ 797\ 587$
$\gamma_3 = 0.169\ 353\ 564$
$\gamma_4 = 0.335\ 966\ 060$
$\gamma_5 = 0.193\ 543\ 669$

EP 0 155 008 B1